Europäisches Patentamt

European Patent Office

Office européen des brevets

(11) Veröffentlichungsnummer: **0 649 228 A1**

## (12) EUROPÄISCHE PATENTANMELDUNG

(21) Anmeldenummer: **94116114.3**

(22) Anmeldetag: **12.10.94**

(51) Int. Cl.⁶: **H04B 10/155**, H03C 7/02

(30) Priorität: **14.10.93 CH 3103/93**

(43) Veröffentlichungstag der Anmeldung:
**19.04.95 Patentblatt 95/16**

(84) Benannte Vertragsstaaten:
**CH DE FR GB LI SE**

(71) Anmelder: **ASCOM TECH AG**
**Berner Technopark**
**Morgenstrasse 129**
**CH-3018 Bern (CH)**

(72) Erfinder: **Azizi, Ataollah Dr.**
**Route de la Gruyère 23**
**CH-1700 Fribourg (CH)**

(74) Vertreter: **Schwerdtel, Eberhard, Dr.**
**Ascom Tech AG**
**Gewerblicher Rechtsschutz**
**Berner Technopark**
**Morgenstrasse 129**
**CH-3018 Bern (CH)**

(54) **Vorrichtung zum Aussenden eines intensitätsmodulierten Lichtstrahls.**

(57) Die Vorrichtung besteht aus einem Modulator (20), der einen Sender (10) zum Aussenden eines Lichtstrahls ansteuert. Der Modulator (20) umfasst eine Mikrowellen-Verzögerungsleitung (25) welche segmentweise durch Varactor-Dioden (27) belastet ist. Dieser Leitung ist ein Hochpassfilter (28) nachgeschaltet und ein Vorverzerrer (30) vorgeschaltet. Der Vorverzerrer arbeitet in Analogtechnik und gleicht die Verzerrung durch die Verzögerungsleitung (25) gerade aus. Hierdurch ergibt sich ein linearer Zusammenhang zwischen der Amplitude des Nutzsignals (NS), das über den einen Eingang (21) eingegeben wird, und der Phase des Hilfsträgersignals (TF), welches über den anderen Eingang (22) eingegeben wird. Das phasenmodulierte Signal ist am Ausgang (23) abgreifbar und dient zum Ansteuern des Senders (10).

Fig. 3

EP 0 649 228 A1

Die Erfindung betrifft eine Vorrichtung mit einem Sender zum Aussenden eines intensitätsmodulierten Lichtstrahls, wobei die Intensitätsmodulation durch ein periodisches Hilfsträgersignal erfolgt, dessen Phasenwinkel in Abhängigkeit von der Amplitude eines Nutzsignals moduliert ist.

Eine Vorrichtung der genannten Art kann als Modulator angesehen werden, der zum Steuern eines Strahlsenders dient. Unter einem Strahlsender ist dabei allgemein jeder Sender zu verstehen, der elektromagnetische Wellen in gebündelter Form aussendet, z.B. zum Speisen einer Koaxialleitung. Im speziellen ist unter einem Strahlsender jedoch vor allem ein Laser zu verstehen, der einen Lichtstrahl aussendet. Dieser Lichtstrahl kann in einem Lichtleiter geführt sein und zum Übertragen von Information dienen.

Zur Informationsübertragung ist es notwendig, den vom Strahlsender ausgesandten Strahl zu modulieren. Bei Lasern kann die Modulation bevorzugt dadurch erfolgen, dass durch Variation des Laserstromes die Intensität des ausgesandten Strahles verändert wird, was einer speziellen Art von Amplitudenmodulation entspricht. Den Vorteilen dieser einfachen Modulationsart steht jedoch ein relativ schlechtes Signal/Rausch-Verhältnis gegenüber.

Die Modulation des Phasenwinkels eines periodischen Trägersignals verhält sich bezüglich des Signal/Rausch-Verhältnisses wesentlich besser als die Amplitudenmodulation, wenn gewisse Bedingungen erfüllt sind wie z.B.geeignete Form des Trägersignals und an die Verhältnisse angepasste Grösse der Phasenamplitude. Für die Informationsübertragung auf Glasfaserstrecken wäre daher die Winkel- oder Phasenmodulation sehr interessant.

Andererseits ergeben sich bei der Modulation des Phasenwinkels eines sehr hochfrequenten Trägersignals, z.B. im Mikrowellenbereich, mit einem breitbandigen Nutzsignal leicht Modulationsverzerrungen, die eine qualitativ ausreichende Übertragung des Nutzsignals verunmöglichen.

Zur Verminderung von Modulationsverzerrungen ist aus der Schrift EP-A-0 160 149 ein Entzerrer-Schaltkreis bekannt, der einem spannungsgesteuerten Oszillator (VCO: voltage controlled oscillator) vorgeschaltet ist, der als Modulator dient. Der Entzerrer-Schaltkreis dient dabei zum Ausgleichen der gegebenen Nichtlinearitäten.

Für Anwendungen der Telekommunikation, z.B. für die Übertragung von Fernsehprogrammen über Verteilnetze, sind weiter verschiedene Modulationsmethoden bekannt. Bei der Methode PPM-SSC (Pulse Phase Modulated-Single Subcarrier) wird z.B. ein impulsförmiges Hilfsträgersignal phasenmoduliert. Nach dem Konvertieren in ein intensitätsmoduliertes, optisches Signal und der Übertragung über eine Lichtleitfaser wird das ankommende Signal optoelektrisch gewandelt, verstärkt und regeneriert, bevor es demoduliert wird, d.h. bevor das übliche amplitudenmodulierte Fernsehsignal zurückgewonnen wird.

Aus diesem Stand der Technik ergibt sich die Aufgabe der Erfindung, eine Winkelmodulationseinrichtung für sehr hohe Trägerfrequenzen und sehr breitbandige Nutzsignale anzugeben, die möglichst linear arbeitet und die es gestattet, z.B. einen entsprechend modulierten Lichtstrahl auf eine Übertragungsstrecke auszusenden. Unter sehr hohe Frequenzen ist hierbei vor allem der GigaHertz-Bereich zu verstehen.

Die Lösung dieser Aufgabe ist durch den kennzeichnenden Teil des unabhängigen Anspruchs gegeben. Die abhängigen Ansprüche geben Einzelheiten und technische Ausgestaltungen an.

Im folgenden wird die Erfindung anhand von drei Figuren beispielsweise beschrieben. Die Figuren zeigen:

Fig. 1 - Blockschaltbild einer Sendeeinrichtung mit einem direkt gesteuerten Laser (Stand der Technik),
Fig. 2 - Blockschaltbild eines ersten Modulators,
Fig. 3 - Blockschaltbild eines zweiten Modulators.

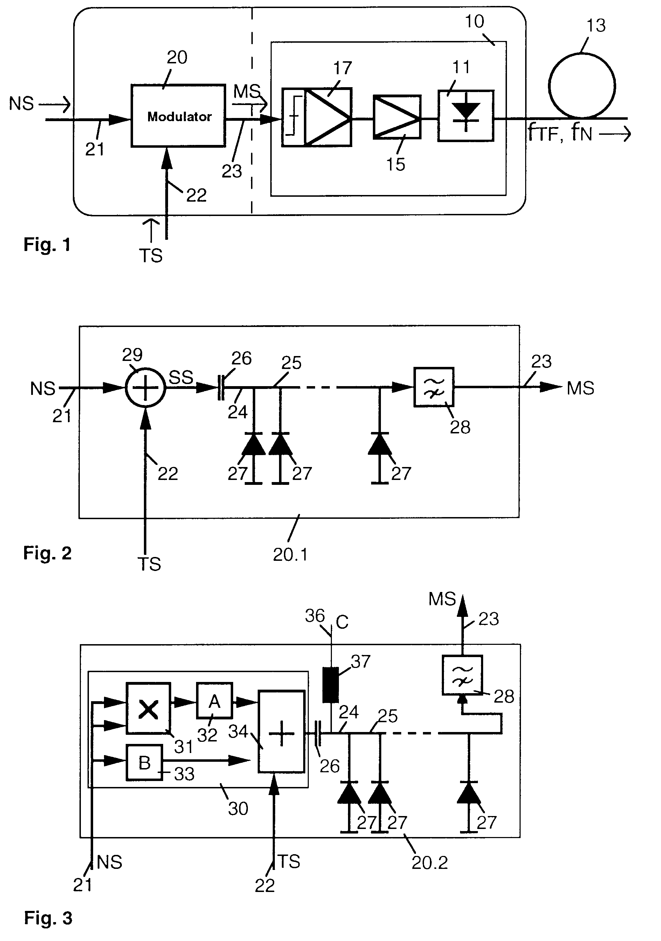

Fig. 1 zeigt als Stand der Technik ein grundsätzliches Blockschaltbild einer Modulationseinrichtung für einen direkt gesteuerten Lasersender. Diese Einrichtung umfasst einen Laser 11, beispielsweise einen Halbleiter-Leistungslaser für das zweite Fenster einer angeschlossenen, abgehenden Lichtleitfaser 13. Der Laser 11 wird durch eine Treiberstufe 15 angesteuert, die wiederum einem Amplitudenbegrenzer 17 nachgeschaltet ist. Die Einheiten 11, 15 und 17 bilden zusammen einen wohlbekannten optischen Sender 10 mit direkt moduliertem Laser. Der ausgesandte Lichtstrahl ist dabei wegen des Amplitudenbegrenzers 17 impulsförmig intensitätsmoduliert bzw. hart getastet (hard limited).

Zur Erzeugung der Modulation des vom Laser 11 ausgesandten Lichtstrahles dient ein dem optischen Sender 10 vorgeschalteter Modulator 20 mit einem Signaleingang 21 für das eigentliche Nutzsignal NS, einem Eingang 22 für ein periodisches Hilfsträgersignal TS und einem Signalausgang 23. An diesem Ausgang 23 wird das Modulationssignal MS ausgegeben, d.h. das periodische Hilfsträgersignal, bei dem die Signalphase durch das Nutzsignal NS moduliert ist. Im Idealfall besteht dabei ein streng linearer Zusammenhang zwischen der Amplitude des Nutzsignals NS und der Phasenauslenkung des Hilfsträgersignals TS.

Fig. 2 zeigt den Aufbau eines ersten Modulators 20.1 der beschriebenen Art. Dieser Modulator besteht aus einer nichtlinearen Verzögerungsleitung 25, der ein Summierer 29 vorgeschaltet und ein Hochpassfilter 28 nachgeschaltet sind. Der Summierer 29 ist mit den Eingängen 21, 22 für das Nutzsignal NS bzw. das Hilfsträgersignal TS verbunden und durch einen Trennkondensator 26 mit dem Eingang 24 der Verzögerungsleitung 25 verbunden. Der Summierer 29 liefert an seinem Ausgang ein Summensignal SS aus Nutzsignal NS und Hilfsträgersignal TS. Die Amplitude des Hilfsträgersignal TS ist dabei erheblich kleiner als die maximale Amplitude des Nutzsignal NS und die Hilfsträgerfrequenz $f_{TS}$ bedeutendhöher als die obere Grenzfrequenz $f_{NS}$ des Nutzsignals NS. Der Kondensator 26 sorgt für die Trennung der Gleichstrom-Potentiale von Summierer 29 und Verzögerungsleitung 25.

Die nichtlineare Verzögerungsleitung 25 besteht aus einer Serienschaltung von Mikrowellenleitungssegmenten, z.B. ausgeführt als Mikro-Streifenleitungssegmente gleicher Länge. Jedes dieser Leitungssegmente ist durch eine Mikrowellen-Varactor-Diode 27 belastet.

Die elektrische Kapazität dieser Varactor-Dioden 27 ist abhängig von der angelegten Spannung in Sperrichtung und beeinflusst die Geschwindigkeit der Signale auf der Verzögerungsleitung. Mit wachsender Kapazität der Varactor-Dioden nimmt die Fortpflanzungsgeschwindigkeit ab. Die Fortpflanzungsgeschwindigkeit eines Signals hängt damit von dessen momentaner Signalamplitude ab.

Diese Tatsache nutzend, steuert im wesentlichen das Nutzsignal NS die Laufzeit jeder Phase des Hilfsträgersignals TS und damit den Phasenwinkel des Hilfsträgers am Ausgang der Verzögerungsleitung 25. Dabei pflanzt sich jede Signalamplitude des Summensignals SS auf der Leitung 25 mit derselben amplitudenabhängigen Geschwindigkeit fort, vorausgesetzt, dass die Dispersion der Leitung 25 im gesamten Frequenzband, welches durch das Summensignal SS beansprucht wird, vernachlässigt werden kann.

Am Ausgang der Leitung 25 unterdrückt das Hochpassfilter 28 das Nutzsignal NS und lässt praktisch nur das phasenmodulierte Hilfsträgersignal als Modulationssignal MS zum Ausgang 23 des Modulators 20.1 passieren.

Der Modulator 20.1 ist relativ einfach. Der Zusammenhang zwischen der Amplitude des Nutzsignals NS und der Phasenauslenkung ist jedoch für die praktische Anwendung nicht genügend linear. Bei der Untersuchung der Art der Nichtlinearität des Modulators 20.1 hat sich gezeigt, dass diese einen ausgeprägten quadratischen Verlauf aufweist. Auf dieser Erkenntnis basiert eine verbesserte Version des beschriebenen Modulators 20.1.

Fig. 3 zeigt das Schaltbild des verbesserten Modulators 20.2. Dieser umfasst - wie gehabt - eine nichtlineare Verzögerungsleitung 25 mit seitlich angeschlossenen Varactor-Dioden 27 und ein nachgeschaltetes Hochpassfilter 28. Statt des Summierers 29 ist ein Vorverzerrer 30 vorgesehen, der über einen Trennkondensator 26 potentialmässig von der Verzögerungsleitung 25 getrennt ist. Der Vorverzerrer 30 umfasst einen Multiplizierer 31, zwei Faktorgeber 32, 33 und einen Addierer 34. Diese in Analogtechnik arbeitenden Funktionsblöcke 31-34 sind so zusammengefügt, dass sie eine Vorverzerrung des Nutzsignals NS bewirken, die weitgehend der Formel

$$V_{out} = A \cdot V^2_{NS} + B \cdot V_{NS} + C$$

entspricht. Hierbei ist $V_{NS}$ die zeitvariable Spannung des Nutzsignals NS am Eingang 21. A, B, und C sind konstante Faktoren. A und B bilden in der Realisierung geeignet zu wählende Widerstandsnetzwerke. Der Faktor C bildet in der Realisierung eine konstante Gleichspannung, die über den Eingang 36 und eine Induktivität 37 an die Verzögerungsleitung 25 angelegt ist. $V_{out}$ bezeichnet schliesslich die zeitvariable Spannung am Ausgang des Verzerrers 30 bzw. am Eingang 24 der Verzögerungsleitung 25. An den Addierer 34 ist weiter noch der Eingang 22 für das periodische Hilfsträgersignal TF angeschlossen.

Der Vorverzerrer 30 verzerrt das am Eingang 21 anliegende Nutzsignal NS so, dass die beschriebene Nichtlinearität des nachfolgenden Modulatorteils gerade kompensiert wird. Es lässt sich hierdurch ein sehr gute Linearität der Kennlinie Modulationswinkel zu Nutzsignal NS erreichen. Dies bedeutet, dass die Funktion

Modulationswinkel = f (Amplitude des Nutzsignals NS)

eine Gerade ist. Bei geeigneter Wahl der Faktoren A, B und C bildet der Modulator 20.2 somit aufgabengemäss eine gute Einheit zum Winkelmodulieren eines hochfrequenter Hilfsträgers TS.

Die Realisierung des Vorverzerrers 30 in z.B. Halbleitertechnik liegt im Können des Fachmannes. Es wird daher hier nicht näher darauf eingegangen.

## Patentansprüche

1. Vorrichtung mit einem Sender (10) zum Aussenden eines intensitätsmodulierten Lichtstrahls,
wobei die Intensitätsmodulation durch ein an einem ersten Eingang (22) anliegendes, periodisches Hilfsträgersignal (TS) erfolgt, dessen Phasenwinkel in Abhängigkeit von der Amplitude eines an einem zweiten Eingang (21) anliegenden Nutzsignals (NS) moduliert ist,
gekennzeichnet,
- durch eine Mikrowellen-Verzögerungsleitung (25), welche segmentweise durch Varactor-Dioden (27) belastet ist,

- durch eine der Verzögerungsleitung (25) vorgeschaltete, mit dem ersten (22) und dem zweiten Eingang (21) verbundene Zusammenführschaltung zum Zusammenführen des Hilfsträgersignals (TS) und des Nutzsignals (NS), und
- durch ein der Verzögerungsleitung (25) nachgeschaltetes Hochpassfilter (28) zum Unterdrücken eines dem Nutzsignal (NS) entsprechenden Frequenzbereiches,

wobei das Hochpassfilter (28) mit seinem Ausgang (23) an den Steuereingang des Senders (10) angeschlossen ist.

2. Vorrichtung nach Anspruch 1,
dadurch gekennzeichnet,
dass die Zusammenführschaltung ein Addierer (29) für das Hilfsträgersignal (TS) und das Nutzsignal (NS) ist.

3. Vorrichtung nach Anspruch 1,
dadurch gekennzeichnet,
dass die Zusammenführschaltung ein Vorverzerrer (30) ist, der sich aus einem Multiplizierer (31), zwei Faktorgebern (32, 33) und einem Addierer (34) so zusammensetzt, dass er (30) der Formel

$$V_{out} = A \cdot V^2_{NS} + B \cdot V_{NS} + C$$

gehorcht, wobei $V_{NS}$ die am zweiten Eingang (21) anliegende Amplitudenspannung des Nutzsignals (NS) ist, wobei A und B konstante Gewichtungsfaktoren sind, wobei C eine konstante Vorspannung ist und wobei $V_{out}$ die zeitvariable Spannung am Ausgang (24) des Vorverzerrers (30) ist.

4. Vorrichtung nach Anspruch 3,
dadurch gekennzeichnet,
dass der Vorverzerrer (30) in Analogtechnik arbeitet.

5. Vorrichtung nach Anspruch 1,
dadurch gekennzeichnet,
dass die Vorrichtung als integrierter Halbleiterbaustein ausgebildet ist.

6. Vorrichtung nach Anspruch 1,
dadurch gekennzeichnet,
dass die Amplitude des Hilfsträgersignals (TS) erheblich kleiner als die maximale Amplitude des Nutzsignals (NS) und die Hilfsträgerfrequenz $f_{TS}$ bedeutend höher als die obere Grenzfrequenz $f_{NS}$ des Nutzsignals (NS) ist.

Fig. 1

Fig. 2

Fig. 3

5

Europäisches
Patentamt

**EUROPÄISCHER RECHERCHENBERICHT**

Nummer der Anmeldung

EP 94 11 6114

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG |
|---|---|---|---|
| A | US-A-3 875 400 (PAO ET AL)<br>* Spalte 5, Zeile 24 - Zeile 36 *<br>* Spalte 5, Zeile 42 - Zeile 55 *<br>* Abbildung 1 *<br>--- | 1-6 | H04B10/155<br>H03C7/02 |
| A | US-A-3 479 615 (GARVER)<br>* Spalte 3, Zeile 30 - Zeile 74 *<br>* Abbildungen 3,5 *<br>--- | 1-6 | |
| A | US-A-3 423 698 (WILSON)<br>* Spalte 2, Zeile 34 - Zeile 45 *<br>* Abbildung 1 *<br>----- | 1-6 | |

RECHERCHIERTE
SACHGEBIETE (Int.CL.6)

H04B
H03C

Der vorliegende Recherchenbericht wurde für alle Patentansprüche erstellt

| Recherchenort | Abschlußdatum der Recherche | Prüfer |
|---|---|---|
| DEN HAAG | 11. Januar 1995 | Williams, M.I. |

EPO FORM 1503 03.82 (P04C03)